# EUROPEAN PATENT SPECIFICATION

(11) **EP 1 006 576 B1**
(45) Date of publication and mention of the grant of the patent: **05.11.2003**
(21) Application number: 99309158.6
(22) Date of filing: 17.11.1999
(51) Int. Cl.: H01L 23/485

(54) **Semiconductor device**
Halbleiteranordnung
Dispositif semi-conducteur

(30) Priority: 30.11.1998 JP 33863998
(43) Date of publication of application: 07.06.2000
(73) Proprietor: SHARP KABUSHIKI KAISHA, Osaka 545-8522 (JP)
(72) Inventor: Ono, Atsushi, Yamatokoriyama-shi, Nara (JP); Chikawa, Yasunori, Kitakatsuragi-gun, Nara (JP)
(74) Representative: Brown, Kenneth Richard

(56) References cited:
- EP-A- 0 646 959
- PATENT ABSTRACTS OF JAPAN vol. 014, no. 156 (E-0908), 26 March 1990 (1990-03-26) & JP 02 014527 A (SEIKO EPSON CORP), 18 January 1990 (1990-01-18)
- PATENT ABSTRACTS OF JAPAN vol. 015, no. 078 (E-1037), 22 February 1991 (1991-02-22) & JP 02 296336 A (SEIKO EPSON CORP), 6 December 1990 (1990-12-06)
- PATENT ABSTRACTS OF JAPAN vol. 001, no. 072 (E-028), 13 July 1977 (1977-07-13) & JP 52 008785 A (CITIZEN WATCH CO LTD), 22 January 1977 (1977-01-22)

## Description

### BACKGROUND OF THE INVENTION

### Field of the Invention

The present invention relates to semiconductor device, and particularly a semiconductor device of an area pad type.

### Description of the Background Art

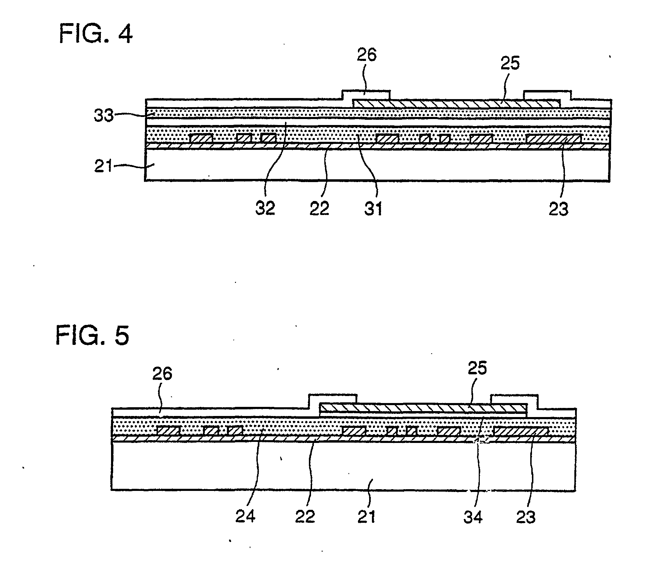

Chips of an area pad type are now becoming practically available. In the area pad type, an electrode pad is formed on an interconnection or an active element for eliminating a region which is occupied only by the electrode pad, and thereby chip sizes are reduced. As shown in Fig. 5, an electrode pad portion of this semiconductor chip is provided with an insulating film 22, a first level interconnection also serving as an active element 23, an interlayer insulating film 24, an electrode pad 25 and a protective film 26 having an opening, which are formed in this order on semiconductor substrate 21. In this case, an interconnection and an active element 23 are formed immediately under electrode pad 25 with an interlayer insulating film 24 therebetween. Therefore, interconnection and active element 23 may be damaged and/or interlayer insulating film 24 may be cracked during wire bonding.

In connection with the above problems, the Japanese Patent Laying-Open No. 1-91439 disclosed an interlayer insulating film, which is made of three layers, which are formed of a plasma nitride film 31, a phase growth oxide film 32 and a vapor growth oxide film 33 containing impurity. This provides a structure having a good coverage and a large strength enough to withstand wire bonding. In Figs. 4 and 5, a reference number 21 indicates a semiconductor substrate, 22 indicates an oxide film, 23 indicates an interconnection and active element, 24 indicates an interlayer insulating film, 25 indicates an electrode pad, 26 indicates a protective film, 31 indicates a plasma nitride film, 32 indicates a vapor growth oxide film, 33 indicates a vapor growth oxide film containing impurity, and 34 indicates an insulating film having a high adhesion to the electrode pad.

In a TCP (Tape Carrier Package) structure in which an Au bump is formed on an electrode pad, a portion under the electrode pad may be damaged when bonding the tape carrier to an inner lead, and the pad may be peeled off.

Techniques relating to formation of an Ni bump on an electrode pad have been disclosed in Japanese Patent Laying-Open No. 8-264541 and others. However, this publication has not disclosed a structure, in which an interconnection or active element is arranged under an electrode pad with an interlayer insulating film therebetween.

However, the foregoing countermeasures require a significant change in wafer manufacturing step, and complicate the manufacturing steps. For employing the above countermeasures in various kinds of devices, an interlayer film must be changed in every process. However, change to the interlayer film cannot be made without difficulty because it affects the quality and characteristics of the devices.

If the pad is not provided with a projection, the quality of the finished interlayer film cannot be controlled without difficulty. For controlling the quality of the interlayer film, it is necessary to bread the wafer for determining the section, resulting in increase in cost. It is also difficult to measure the adhesion between the interlayer film and the electrode pad. Accordingly, even when a certain trouble occurred due to insufficient adhesion between them, the problem cannot be found before performing actual assembly so that products including such troubles may be placed on the market, resulting in another problem.

JP-A-02014527 discloses a semiconductor device according to the preamble of claim 1.

### SUMMARY OF THE INVENTION

According to the invention there is provided a semiconductor device comprising an interconnection or active element formed on a substrate, and an electrode pad formed on said interconnection or active element with an interlayer insulating film therebetween, wherein a projecting electrode is formed on the surface of said electrode pad for protecting said interconnection or active element during bonding to an external terminal, characterised in that said projecting electrode is formed of at least one kind of material selected from a group consisting of Ni, Cu, Cu alloy and Ni alloy, and said projecting electrode has a height ranging from 0.5 µm to 10 µm.

Preferably, the projecting electrode has a surface film made of at least one kind of material selected from a group consisting of Au, Pt and Ag.

The surface film preferably has a thickness ranging from 0.05 µm to 2 µm.

The projecting electrode is formed only in a formation region of the electrode pad.

The projecting electrode may be formed of an NiP layer having a phosphorus content of 7% to 11%.

The semiconductor device is preferably provided with a protective film extending from a position above the interlayer insulating film to a position above a periphery of the electrode pad, and having an opening on the electrode pad. In this structure, the projecting electrode extends from a position above the electrode pad located in the opening to a position above the protective film.

The semiconductor device may include an external interconnection joined to the projecting electrode by the bonding.

The external interconnection preferably includes a bonding wire or lead.

Embodiments of the present invention will now be described by way of example with reference to the accompanying drawings.

### BRIEF DESCRIPTION OF THE DRAWINGS

Fig. 1 is a cross section showing a sectional structure of a pad of a semiconductor chip according to the invention;
Fig. 2 is a cross section showing the sectional structure of the pad of the semiconductor chip according to the invention together with a TCP attached thereto;
Fig. 3 is a cross section showing the sectional structure of the pad of the semiconductor chip according to the invention together with a plastic mold package and a substrate (printed board or ceramic board);
Fig. 4 is a cross section showing by way of example the pad structure of the semiconductor chip in the prior art; and
Fig. 5 is a cross section showing another example of the pad structure of the semiconductor chip in the prior art.

### DESCRIPTION OF THE PREFERRED EMBODIMENTS

The invention will now be described in greater detail with reference to embodiments.

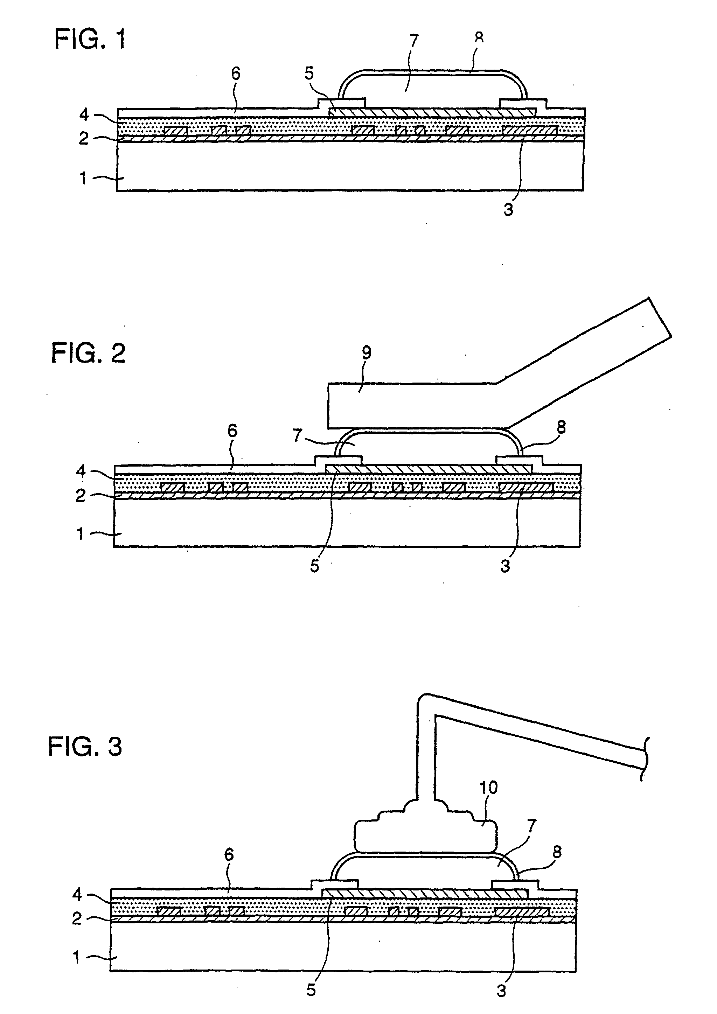

Fig. 1 is a cross section showing a sectional structure of a pad of a semiconductor chip according to the invention. A reference number 1 indicates a semiconductor substrate, 2 indicates an oxide film, 3 indicates an interconnection and active element, 4 indicates an interlayer insulating film, 5 indicates an electrode pad, 6 indicates a protective film, 7 indicates an NiP layer (projecting electrode) and 8 indicates an Au layer (surface layer).

As shown in Fig. 1, insulating layer 2, first-level interconnection and active layer 3, interlayer insulating film 4, electrode pad 5 and protective film 6 having an opening are formed in this order on semiconductor substrate 1. NiP layer 7 which contains 7% to 11% phosphorus and forms the projecting electrode of 5 µm in height as well as Au layer 8 which is 1 µm in thickness and forms a surface film for protecting the surface of the projecting electrode are formed in this order in the opening. NiP layer 7 and Au layer 8 are formed by electroless plating. For withstanding impacts during wire bonding and inner lead bonding, NiP layer 7 must have a height of 0.5 µm or more. Also, the height of NiP layer 7 is preferably 10 µm or less in view of reduction of a time required for forming NiP layer 7. Instead of the NiP layer, a similar effect can be achieved by a layer which is made of a material selected from a group including Ni, Cu, Ni alloy and Cu alloy.

For preventing surface oxidation of NiP layer 7, Au layer 8 is merely required to have a thickness of 0.05 µm or more. Even in the case where it is to be used for eutectic bonding with Sn, Au layer 8 is merely required to have a thickness of 2 µm or more. For reduction of the time required for forming Au layer 8, Au layer 8 preferably has a thickness in a range from 0.05 µm to 2 µm. Instead of Au layer 8, the layer may be made of a noble metal such as Pt or Ag, or may be formed of a composite layer containing the noble metal, in which case a similar effect can be achieved.

A method of forming NiP layer 7 and Au layer 8 will now be described.

First, A1 on the surface of electrode pad 5, which is exposed through the opening formed in protective film 6, is replaced with Zn allowing a replacement (substitution) reaction with Ni. Then, the chip is immersed into a plating solution, and electroless plating is performed to form NiP layer 7 having a thickness of 5 µm measured from protective film 6. Deposition of NiP by this electroless plating has a selectivity.

An Ni layer is formed by a replacement reaction, which occurs between Ni and the Zn layer formed on the surface of electrode pad 5. Then, electroless plating progresses on the surface of the Ni layer owing to the autocatalysis. Accordingly, it is not necessary to form a resist pattern for plating. Further, it is not necessary to form a conductive film for plating on the wafer surface owing to the electroless plating.

The electroless Ni plating solution used for the above is a general solution which is primarily made of nickel sulfate and sodium hypophosphite.

Then, Au layer 8 is formed on NiP layer 7. Ni on the surface of NiP layer 7 is replaced with Au using a substitution Au plating solution. This reaction is a replacement reaction, and Au layer 8 which is formed by this reaction can have a thickness of 0.1 µm or less. This thickness is large enough to protect the surface of NiP layer 7 by Au layer 8.

Further, electroless Au plating is further performed to increase the thickness of Au layer 8 to 1 µm. The electroless Au plating solution is primarily made of Au sodium sulfite.

At this time, NiP layer 7 covers the opening of protective film 6, and does not have a portion protruding from a region where electrode pad 5 is formed. Owing to this structure, NiP layer 7 protected by Au layer 8 covers the protection opening, and serves to protect electrode pad 5 from corrosion and others. Owing to the structure where NiP layer 7 does not protrude from electrode pad 5, a stress can be relieved so that peeling of the pad and scooping of the underlying semiconductor substrate can be prevented.

Since strengths of electrode pad 5 and its underlying portion can be measured through NiP layer, the adhesion can be controlled.

Fig. 2 is a cross section of the semiconductor chip of the TCP. In the semiconductor chip, insulating layer 2, first-level interconnection and active layer 3, interlayer insulating film 4, electrode pad 5 and protective film 6 having an opening are formed in this order on semiconductor substrate 1. NiP layer 7 containing 7% to 11% phosphorus as well as Au layer 8 are formed in this order in the opening.

A tape carrier (not shown) has an insulating film having a device hole, and a conductor pattern is adhered onto this insulating film by adhesive. A conductor pattern which is integral with the foregoing conductor pattern is extended into the device hole, and a conductor lead 9 is coated with Sn plating.

In the TCP described above, the bonding between the semiconductor chip and the tape carrier is achieved by Au-Sn eutectic crystal, which is formed by thermo compression bonding between Au layer 8 on electrode pad 5 and the Sn layer of conductor lead 9.

After the thermo compression deposition, conductor lead 9 and projecting electrode 7 were removed, and the states of electrode pad 5 and its underlying portion were determined. Even under such conditions that the load was 50 gram-weight (0.49 newton) per electrode and the temperature was 560°C, no damage was caused. Under the same conditions, a projecting electrode made of only Au was determined. In this case, it was found that the electrode pad and the underlying portion were damaged.

Fig. 3 is a cross section of the semiconductor chip according to the invention, which is housed in a plastic mold package and is mounted on a substrate (printed board or ceramic board: not shown). Even in the structure where a wire 10 is bonded onto projecting electrode 7 as shown in Fig. 3, damages which may be caused to electrode pad 5 and the underlying portion by the wire bonding can be prevented, similarly to the case of the TCP. The description has been given on the example in which the hard projecting electrode is formed of Ni-contained metal. Instead of this, Cu-contained metal may be used as a hard material of the projecting electrode which can be formed of electroless plating.

According to the invention, as described above, the projecting electrode relieves the impact which may occur during wire bonding or inner lead bonding, even when the wire bonding or inner lead bonding is performed on the electrode pad. Therefore, no damage is caused to the electrode pad as well as the interlayer insulating film, and the interconnection layer and active layer under the pad. Accordingly, it is possible to improve yield during assembly as well as reliability of connection. Since the hard projecting electrode is formed in the protective film opening on the electrode pad, it is possible to measure a shearing strength in a lateral direction and detect an adhesive strength so that adhesion can be determined before the assembly. The structure in the prior art is not provided with a projecting electrode, and therefore is not provided with a catch, hook or the like so that measurement is physically impossible in the prior art. By forming the projecting electrode, a tool of measuring the shearing strength or the like can be hooked on the projecting electrode, and thereby the measurement of the shearing strength can be performed.

By forming the surface film made of an Ag layer, Pt layer, Au layer or the like on the surface of the projecting electrode, the surface oxidation of the projecting electrode can be prevented. Further, no problem arises even if it is used for eutectic bonding between the Au layer and Sn.

Since the Cu layer, Ni layer, Cu alloy layer, Ni alloy layer, Ag layer, Pt layer and Au layer can be formed by electroless plating, complicated steps for electrolytic plating are not required.

By forming the projecting electrode in the electrode pad formation region, it is possible to prevent peeling of the electrode pad and scooping of the underlying semiconductor substrate, which may be caused by a stress applied from the projecting electrode.

## Claims

1. A semiconductor device comprising an interconnection or active element (3) formed on a substrate (1), and an electrode pad (5) formed on said interconnection or active element (3) with an interlayer insulating film (4) therebetween, wherein
a projecting electrode (7) is formed on the surface of said electrode pad (5) for protecting said interconnection or active element (3) during bonding to an external terminal,
**characterised in that**
said projecting electrode (7) is formed of at least one kind of material selected from a group consisting of Ni, Cu, Cu alloy and Ni alloy, and
said projecting electrode (7) has a height ranging from 0.5 µm to 10 µm.

2. A semiconductor device according to claim 1, wherein
said projecting electrode (7) has a surface film (8) made of at least one kind of material selected from a group consisting of Au, Pt and Ag.

3. A semiconductor device according to claim 1, wherein
said projecting electrode (7) is formed only in a formation region of said electrode pad (5).

4. A semiconductor device according to claim 2, wherein
said surface film (8) has a thickness ranging from 0.05 µm to 2 µm.

5. A semiconductor device according to claim 1, wherein
said projecting electrode (7) is formed of an NiP layer, and
said NiP layer has a phosphorus content of 7% to 11%.

6. A semiconductor device according to any preceding claim, further comprising:
a protective film (6) extending from a position above said interlayer insulating film (4) to a position above a periphery of said electrode pad (5), and having an opening on said electrode pad (5), wherein
said projecting electrode (7) extends from a position above said electrode pad (5) located in said opening to a position above said protective film (6).

7. A semiconductor device according to any preceding claim, further comprising:
an external interconnection (9, 10) joined to said projecting electrode (7) by the bonding.

8. A semiconductor device according to claim 7, wherein
said external interconnection (9, 10) includes a bonding wire or lead.

## Patentansprüche

1. Halbleiterbauteil mit einer auf einem Substrat (1) ausgebildeten Verbindung oder einem aktiven Element (3) und einem auf der Verbindung oder dem aktiven Element (3) ausgebildeten Elektroden-Kontaktfleck (5) mit einem dazwischen ausgebildeten Zwischenschicht-Isolierfilm (4) ;
- wobei auf der Oberfläche des Elektroden-Kontaktflecks (5) zum Schützen der Verbindung oder des aktiven Elements (3) während des Verbindens mit einem externen Terminal eine vorstehende Elektrode (7) ausgebildet ist;
**dadurch gekennzeichnet, dass**
- die vorstehende Elektrode (7) aus mindestens einer aus der aus Ni, Cu, einer Cu-Legierung und einer Ni-Legierung bestehenden Gruppe ausgewählten Materialart besteht; und
- die vorstehende Elektrode (7) eine Höhe im Bereich von 0,5 µm bis 10 µm aufweist.

2. Halbleiterbauteil nach Anspruch 1, bei dem die vorstehende Elektrode (7) einen Oberflächenfilm (8) aus mindestens einem aus der aus Au, Pt und Ag bestehenden Gruppe ausgewählten Materialart besteht.

3. Halbleiterbauteil nach Anspruch 1, bei dem die vorstehende Elektrode (7) nur in einem Ausbildungsbereich des Elektroden-Kontaktflecks (5) ausgebildet ist.

4. Halbleiterbauteil nach Anspruch 2, bei dem der Oberflächenfilm (8) eine Dicke im Bereich von 0,05 µm bis 2 µm aufweist.

5. Halbleiterbauteil nach Anspruch 1, bei dem die vorstehende Elektrode (7) aus einer NiP-Schicht besteht, die einen Phosphorgehalt von 7 % bis 11 % aufweist.

6. Halbleiterbauteil nach einem der vorstehenden Ansprüche, ferner mit:
- einem Schutzfilm (6), der sich von einer Position über dem Zwischenschicht-Isolierfilm (4) bis an eine Position über dem Umfang des Elektroden-Kontaktflecks (5) erstreckt, und mit einer Öffnung auf dem Elektroden-Kontaktfleck (5);
- wobei sich die vorstehende Elektrode (7) von einer Position über dem Elektroden-Kontaktfleck (5) in der Öffnung bis an eine Position über dem Schutzfilm (6) erstreckt.

7. Halbleiterbauteil nach einem der vorstehenden Ansprüche, ferner mit:
- einer externen Verbindung (9, 10), die durch Bonden mit der vorstehenden Elektrode (7) verbunden ist.

8. Halbleiterbauteil nach Anspruch 7, bei dem die externe Verbindung (9, 10) einen Bonddraht oder eine Leitung beinhaltet.

## Revendications

1. Dispositif à semi-conducteur comprenant une interconnexion ou un élément actif (3) réalisé(e) sur un substrat (1), et un contact d'électrode (5) réalisé-sur ladite interconnexion ou ledit élément actif (3) en interposant un film d'isolation inter-couche (4) entre eux, dans lequel
une électrode saillante (7) est réalisée à la surface dudit contact d'électrode (5) afin de protéger ladite interconnexion ou ledit élément actif (3) lors de la soudure sur une borne externe,
**caractérisé en ce que**
ladite électrode saillante (7) est constituée d'au moins un type de matériau choisi dans un groupe constitué des éléments Ni, Cu, un alliage Cu et un alliage Ni, et
ladite électrode saillante (7) présente une hauteur comprise entre 0,5 µm et 10 µm.

2. Dispositif à semi-conducteur selon la revendication 1, dans lequel
ladite électrode saillante (7) est munie d'un film de surface (8) constitué d'au moins un type de matériau choisi dans un groupe constitué des éléments Au, Pt et Ag.

3. Dispositif à semi-conducteur selon la revendication 1, dans lequel
ladite électrode saillante (7) n'est réalisée que dans une région de formation dudit contact d'électrode (5).

4. Dispositif à semi-conducteur selon la revendication 2, dans lequel
ledit film de surface (8) présente une épaisseur comprise entre 0,05 µm et 2 µm.

5. Dispositif à semi-conducteur selon la revendication 1, dans lequel
ladite électrode saillante (7) est constituée d'une couche NiP, et ladite couche NiP présente une teneur en phosphore comprise entre 7 % et 11 %.

6. Dispositif à semi-conducteur selon l'une quelconque des revendications précédentes, comprenant en outre :
un film de protection (6) qui s'étend entre une position située au-dessus dudit film d'isolation inter-couche (4) et une position située au-dessus d'une périphérie dudit contact d'électrode (5), et qui est muni d'une ouverture sur ledit contact d'électrode (5), dans lequel
ladite électrode saillante (7) s'étend entre une position située au-dessus dudit contact d'électrode (5) placé dans ladite ouverture et une position située au-dessus dudit film de protection (6).

7. Dispositif à semi-conducteur selon l'une quelconque des revendications précédentes, comprenant en outre :
une interconnexion externe (9, 10) liée à ladite électrode saillante (7) par la soudure.

8. Dispositif à semi-conducteur selon la revendication 7, dans lequel
ladite interconnexion externe (9, 10) comprend un fil ou un conducteur à souder.
